# EUROPEAN PATENT SPECIFICATION

(11) **EP 3 703 129 B1**
(45) Date of publication and mention of the grant of the patent: **20.10.2021**
(21) Application number: 19160035.2
(22) Date of filing: 28.02.2019
(51) Int. Cl.: H01L 27/146

(54) **RADIATION SENSOR ELEMENT AND CORRESPONDING METHOD**
STRAHLUNGSSENSORELEMENT UND VERFAHREN DAZU
CAPTEUR DE RAYONNEMENT ET PROCÉDÉ DE FABRICATION CORRESPONDANT

(43) Date of publication of application: 02.09.2020
(73) Proprietor: Detection Technology Oy, 90590 Oulu (FI)
(72) Inventor: HEIKKINEN, Petteri, 90590 Oulu (FI); JOHANSSON, Mikael, 90590 Oulu (FI)
(74) Representative: Papula Oy

(56) References cited:
- US-A1- 2009 079 094
- US-A1- 2011 101 523
- US-A1- 2011 101 523
- US-A1- 2015 276 945
- US-A1- 2016 148 965

## Description

### FIELD OF TECHNOLOGY

The invention concerns the technology of radiation detectors. In particular, the invention concerns interconnections for radiation detectors. The documents US2015/276945A and US2011101523A are related prior arts.

### BACKGROUND

Radiation detectors are widely used for detecting ionizing radiation in experimental and applied particle and nuclear physics, as well as in the medical and environmental fields. Radiation detectors may also be used, for example, in various safety and military applications. One of the most advantageous types of radiation detectors are so-called solid-state detectors, i.e., semiconductor detectors. Such detectors may generally provide improved ease of use, longer lifecycle, smaller size, as well as higher resolution and sensitivity compared to other types of radiation sensors. Especially in applications dealing with X-rays and gamma radiation, usage of solid-state detectors with sensor elements comprising compound semiconductor materials, such as cadmium telluride (CdTe) or cadmium zinc telluride (CdZnTe), may be beneficial, since such detectors may commonly be operated at room temperature.

However, back-end processing may prove challenging for compound semiconductor sensor elements. Such challenges may be related, for example, to temperature-sensitivity of the compound semiconductor material(s) used and the high resolution levels required of modern devices. In light of this, it may be desirable to develop new solutions related to back-end processing of compound semiconductor sensor elements.

### SUMMARY

This summary is provided to introduce a selection of concepts in a simplified form that are further described below in the Detailed Description. This Summary is not intended to identify key features or essential features of the claimed subject matter, nor is it intended to be used to limit the scope of the claimed subject matter.

According to a first aspect, a radiation sensor element is provided. The radiation sensor element comprises a read-out integrated circuit having an interconnection face, a compound semiconductor layer opposite the interconnection face, and a copper-pillar interconnection element extending from the interconnection face towards the compound semiconductor layer.

The copper-pillar interconnection element comprises a copper part and an oxidation barrier layer, comprising a noble metal and arranged between the copper part and the compound semiconductor layer.

According to a second aspect, a method for fabricating a radiation sensor element is provided. The method comprises providing a read-out integrated circuit having an interconnection face, forming a copper-pillar interconnection element on the interconnection face, providing a compound semiconductor layer, and arranging the compound semiconductor layer opposite the interconnection face such that the copper-pillar interconnection element extends from the interconnection face towards the compound semiconductor layer.

In the method, the copper-pillar interconnection element comprises a copper part and an oxidation barrier layer, comprising a noble metal, and the oxidation barrier layer is arranged between the copper part and the compound semiconductor layer.

### BRIEF DESCRIPTION OF THE DRAWINGS

The present disclosure will be better understood from the following detailed description read in light of the accompanying drawings, wherein:
**FIG. 1** depicts a schematic exploded view of a radiation sensor element,
**FIGs. 2a, 2b, and 2c** depict partial cross-sectional views of various radiation sensor elements, and
**FIG. 3** illustrates a method for fabricating a radiation sensor element,
**FIGs. 4a, 4b, 4c, 4d, 4e, 4f****,** **4g, 4h, 4i, 4j, 4k, and 4l** depict stages of a method for fabricating a radiation sensor element,
**FIGs. 5a, 5b, 5c, 5d, 5e, and 5f** depict stages of a method for fabricating a copper-pillar interconnection element.

Unless specifically stated to the contrary, any drawing of the aforementioned drawings may be not drawn to scale such that any element in said drawing may be drawn with unrealistic proportions with respect to other elements in said drawing in order to emphasize certain structural aspects of the embodiment of said drawing.

Moreover, corresponding elements in the embodiments of any two drawings of the aforementioned drawings may be disproportionate to each other in said two drawings in order to emphasize certain structural aspects of the embodiments of said two drawings.

### DETAILED DESCRIPTION

Concerning radiation sensor elements and methods discussed in this detailed description, the following shall be noted.

Herein, "radiation" is to be understood broadly, covering, for example, electromagnetic radiation and particle radiation. Radiation may generally correspond to ionizing radiation or non-ionizing radiation.

In this specification, "ionizing" radiation may refer to radiation with particle or photon energies less than 10 electron volts (eV), whereas "non-ionizing" radiation may refer to radiation with particle or photon energies of at least 10 eV.

Throughout this specification, a "radiation detector" may refer to a complete, operable radiation detector. A radiation detector may generally comprise at least one radiation sensor. A radiation detector may comprise also other elements, units, and/or structures.

In this disclosure, a "radiation sensor" may refer to an operable unit, module, or device configured to detect and/or measure radiation and to register, indicate, and/or respond to said radiation.

Further, a "radiation sensor element" may refer to an element, which may form, as such, a radiation sensor. Alternatively, a radiation sensor element may be used as one element of a radiation sensor comprising also other elements and/or structures. A radiation sensor element may comprise an active material, a physical property of which is utilized in said radiation sensor element in order to register, indicate, and/or respond to radiation incident on said active material. A radiation sensor element may correspond to an indirect-conversion radiation sensor element or a direct-conversion radiation sensor element.

Herein, an "indirect-conversion radiation sensor element" may refer to a radiation sensor element comprising a scintillator material for converting ionizing radiation to non-ionizing electromagnetic radiation and a semiconductor photodetector for detecting the electromagnetic radiation emitted by the scintillator.

By contrast, a "direct-conversion radiation sensor element" may refer to a radiation sensor element not requiring the use of a scintillator to convert ionizing radiation to non-ionizing electromagnetic radiation in order to detect said ionizing radiation. Such direct-conversion radiation sensor elements may be based on detecting free charge carriers produced by incident radiation, e.g., ionizing radiation, within an active material. A direct-conversion radiation sensor element may generally comprise a semiconductor material as an active material.

Herein, a "semiconductor" material may refer to a material possessing a conductivity intermediate between the conductivity of conductive materials, such as metals, and the conductivity of insulating materials, such as many plastics and glasses. A semiconductor material may generally have a doping level, which may be adjusted in order to tune properties of said semiconductor material in a controllable manner.

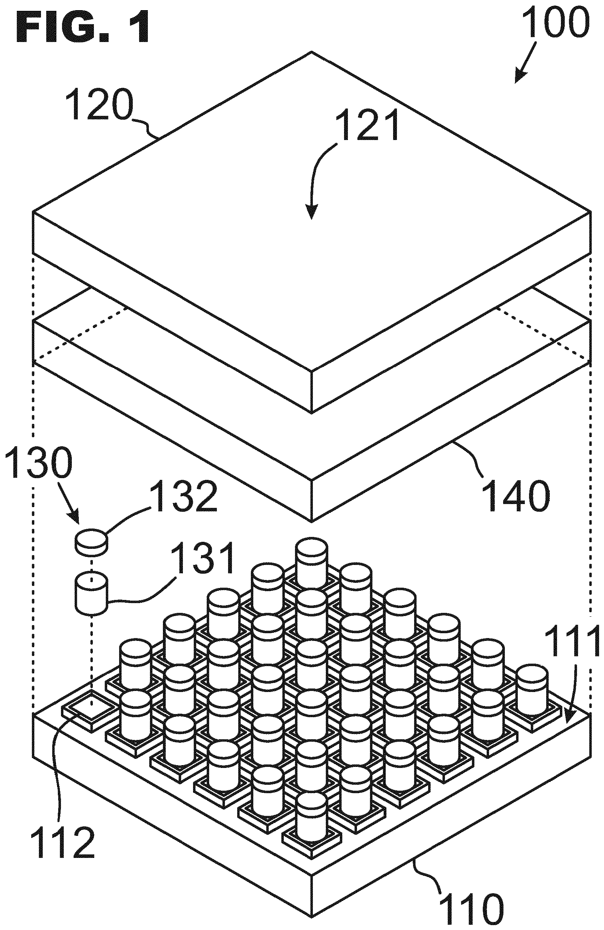

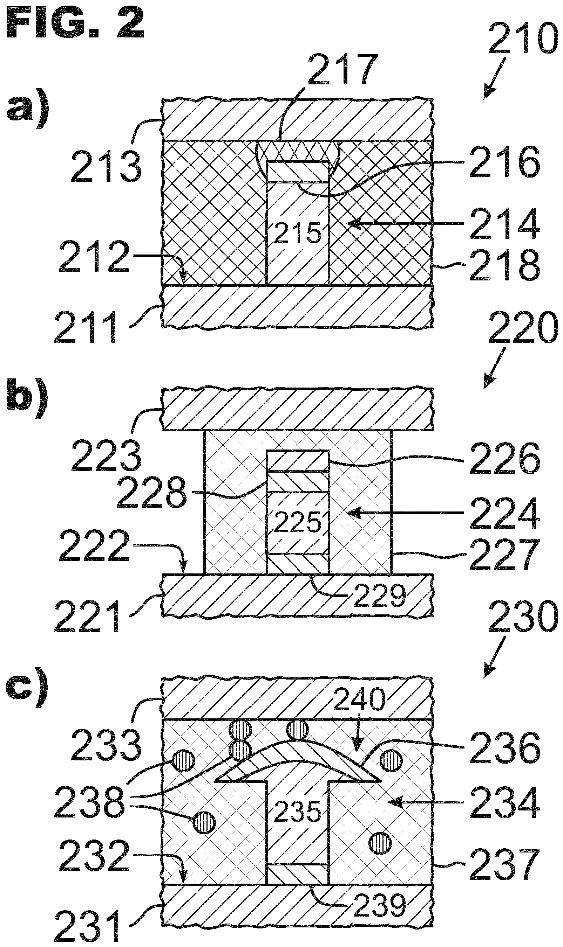

FIG. 1 depicts a schematic exploded view of a radiation sensor element 100 according to an embodiment. The embodiment of FIG. 1 may be in accordance with any of the embodiments disclosed with reference to, in conjunction with, and/or concomitantly with FIG. 2. Additionally or alternatively, although not explicitly shown in FIG. 1, the embodiment of FIG. 1 or any part thereof may generally comprise any features and/or elements of any of the embodiments of FIG. 2 which are omitted from FIG. 1.

In the embodiment of FIG. 1, the radiation sensor element 100 comprises a read-out integrated circuit 110.

In this disclosure, an "integrated circuit" may refer to a body or an element comprising electrical circuitry formed on a piece of semiconductor material, such as silicon (Si).

As such, a "read-out integrated circuit" may refer to an integrated circuit configured to accumulate charge generated by incident radiation within an active material of a radiation sensor element. Additionally or alternatively, a read-out integrated circuit may refer to an integrated circuit configured to move such charge away from said active material for further processing. A read-out integrated circuit may generally be configured to operate in a pixel-wise manner.

The read-out integrated circuit 110 of the embodiment of FIG. 1 has an interconnection face 111.

Herein, a "face" may refer to a part of a surface of a body or an element. A face may specifically refer to a part of a surface of a body or an element viewable from a particular viewing direction. A face or a body or an element may generally have a pre-defined function in the operation of said body or said element.

Consequently, an "interconnection face" may refer to a face of a body or an element configured to or suitable for electrically coupling said body or element to another body or element. In particular, an interconnection face of a read-out integrated circuit of a radiation sensor element may refer to a face of said read-out integrated circuit configured to or suitable for electrically coupling said read-out integrated circuit to active material of said radiation sensor element.

In the embodiment of FIG. 1, the interconnection face 111 comprises a plurality of interconnection pads 112. In other embodiments, an interconnection face may or may not comprise any suitable additional structural feature (s), such as an interconnection pad, for enabling and/or facilitating the provision of an electrical connection between a read-out integrated circuit and an active material.

In a practical application, a read-out integrated circuit may comprise various technical features related, for example, to design of individual semiconductor devices, isolation of individual devices, and/or internal electrical connections between individual devices. Such features are, however, omitted for brevity and conciseness.

In the embodiment of FIG. 1, the radiation sensor element 100 comprises a compound semiconductor layer 120 opposite the interconnection face 111.

Throughout this specification, a "compound semiconductor" may refer to a semiconductor compound comprising at least two different chemical elements. A compound semiconductor material may correspond, for example, to a binary, a ternary, or a quaternary compound. Some compound semiconductor materials, or material systems, may exhibit highly tunable properties based on an elemental composition thereof. One example of such tunable compound semiconductor material system is cadmium zinc telluride (CdZnTe), an alloy of cadmium telluride (CdTe) and zinc telluride (ZnTe).

On the other hand, a "layer" may refer to a generally sheet-shaped element arranged on a surface or a body. Additionally or alternatively, a layer may refer to one of a series of superimposed, overlaid, or stacked generally sheet-shaped elements. A layer may generally comprise a plurality of sublayers of different materials or material compositions. Some layers may be path-connected, whereas other layers may be locally path-connected and disconnected.

As such, a "compound semiconductor layer" may refer to a layer comprising a compound semiconductor material. Said compound semiconductor material may generally correspond to an active material of a radiation sensor element.

The compound semiconductor layer 120 of the embodiment of FIG. 1 comprises a radiation receiving face 121. Generally, radiation to be detected using a radiation sensor element may arrive inside a compound semiconductor layer of said radiation sensor element through such radiation introduction face.

Although not shown in FIG. 1, a compound semiconductor layer may be supplied with a bias voltage for collecting and/or detecting electrical charge(s) brought about by incident radiation. Additionally, some radiation sensor elements may comprise a scintillator coupled to a compound semiconductor layer for converting energy of incident radiation to light detectable by said radiation sensor elements. Such scintillators may be unnecessary in case of direct-conversion sensor elements.

The radiation sensor element 100 of the embodiment of FIG. 1 comprises a plurality of copper-pillar interconnection elements extending from the interconnection face 111 towards the compound semiconductor layer 120. More specifically, the copper-pillar interconnection elements extend from a plurality of interconnection pads. In other embodiments, a radiation sensor element may comprise one or more copper-pillar interconnection element(s). In said other embodiments, said copper-pillar interconnection element(s) may or may not extend from interconnection pad(s).

In this disclosure, an "interconnection element" may refer to an element via which electrical current may pass between a read-out integrated circuit and a compound semiconductor layer.

Consequently, a "copper-pillar interconnection element" may refer to an interconnection element comprising (metallic) copper (Cu) and having a generally pillar-shaped and/or protruding form.

In FIG. 1, a single copper-pillar interconnection element 130 is shown as being separated from the interconnection face 111. Although the copper-pillar interconnection element 130 is depicted in FIG. 1 as being separated from the interconnection face 111, the copper-pillar interconnection element 130 may extend from the interconnection pad 112.

In the embodiment of FIG. 1, the copper-pillar interconnection 130 has a rotationally symmetric shape. In particular, the copper-pillar interconnection 130 has a cylindrical shape. In other embodiments, a copper-pillar interconnection may or may not have a rotationally symmetric, such as cylindrical, shape.

In some embodiments, a copper-pillar interconnection may have a height in a height direction perpendicular to an interconnection face, for example, in a range from a few micrometers to some tens of micrometers. In other embodiments, a copper-pillar interconnection may have any other suitable height.

In some embodiments, a copper-pillar interconnection may have a width, such as a diameter, in a lateral direction perpendicular to a height direction, for example, in a range from a few micrometers to some tens of micrometers. In other embodiments, a copper-pillar interconnection may have any other suitable width.

In the embodiment of FIG. 1, the copper-pillar interconnection element 130 comprises a copper part 131 and an oxidation barrier layer 132. The oxidation barrier layer 132 comprises a noble metal and is arranged between the copper part 131 and the compound semiconductor layer 120.

Throughout this specification, an "oxidation barrier layer" may refer to a layer suitable for inhibiting or reducing oxidation of at least part of a surface of a copper part, especially during fabrication of a radiation sensor element. Additionally or alternatively, an oxidation barrier layer may refer to a layer comprising a noble metal, e.g., metallic noble metal. Additionally or alternatively, an oxidation barrier layer may exhibit a rate of oxidation under standard temperature and pressure (STP) conditions substantially lower than a rate of oxidation of Cu under STP conditions.

Herein, a "noble metal" may refer to a material comprising noble metal atoms. Such noble metal atoms may generally exist in metallic form, i.e., they may form one or more metallic phase(s). Additionally or alternatively, the term "noble metal" may refer to a material comprising gold (Au), silver (Ag), rhodium (Rh), platinum (Pt), palladium (Pd), ruthenium (Ru), osmium (Os), and/or iridium (Ir).

An oxidation barrier layer, comprising a noble metal, may generally increase oxidation resistance of a copper-pillar interconnection, thereby facilitating intermediate storing of a read-out integrated circuit during the fabrication process of a radiation sensor element.

In some embodiments, an oxidation barrier layer may comprise at least 90 atomic percent of noble metal(s). Such composition may provide exceptionally high oxidation resistance. In other embodiments, an oxidation barrier layer may or may not comprise at least 90 atomic percent of noble metal(s).

The radiation sensor element 100 of the embodiment of FIG. 1 further comprises electrically conductive adhesive 140 between the copper-pillar interconnection 130 and the compound semiconductor layer 120. Although the electrically conductive adhesive 140 is depicted in FIG. 1 as being separated from the copper-pillar interconnection 130, the electrically conductive adhesive 140 may be electrically connected to the copper-pillar interconnection 130. Moreover, electrically conductive adhesive may generally be provided in any shape or as a plurality of individual dots and/or other patterns, despite FIG. 1 depicting the electrically conductive adhesive 140 as a single block. In other embodiments, a radiation sensor element may or may not comprise electrically conductive adhesive.

In this specification, "electrically conductive adhesive" may refer to a glue suitable for sticking or attaching objects to one another and having high average electrical conductivity, for example, an average electrical conductivity of at least 1 siemens per meter (S/m), or at least 10 S/m, or at least 100 S/m, or at least 1000 S/m at 20 degrees Celsius (°C). Electrically conductive adhesive may comprise pieces of conductive material suspended in an adhesive material, i.e., an adhesive matrix. Said pieces of conductive material may generally comprise any kind(s) of conductive material(s), such as, Ag, Cu, nickel (Ni), and/or conductive allotropes of carbon (C). On the other hand, said adhesive matrix may comprise any suitable adhesive material(s), such as, varnish(es), resin(s), and/or silicone. In different types of electrically conductive adhesives, mixing ratios between masses of conductive materials and masses of adhesive materials may vary substantially.

An oxidation barrier layer, comprising a noble metal, may generally facilitate formation of a highly conductive electrical connection between a copper part of a copper-pillar interconnection and an electrically conductive adhesive. On the other hand, electrically conductive adhesive between a copper-pillar interconnection and a compound semiconductor layer may enable forming an electrical connection between a read-out integrated circuit and a compound semiconductor layer in a reliable, high-throughput manner.

FIGs. 2a, 2b, and 2c, collectively referred to throughout this specification as FIG. 2, depict partial cross-sectional views of radiation sensor elements 210, 220, 230 according to different embodiments. Although not explicitly shown in FIG. 2, any of the embodiments of FIG. 2 or any part thereof may generally comprise any features and/or elements of any of the embodiments described within this specification which are omitted from FIG. 2. Furthermore, since FIG. 2 depicts cross sections of parts of radiation sensor elements 210, 220, 230, FIG. 2 does not limit shapes of the embodiments of FIGs. 2a-2c or any part(s) thereof in any direction forming an angle with cross-sectional planes of the drawings in question.

In the embodiments of FIG. 2, each of the radiation sensor elements 210, 220, 230 comprises a read-out integrated circuit 211, 221, 231 having an interconnection face 212, 222, 232; a compound semiconductor layer 213, 223, 233 opposite the interconnection face 212, 222, 232; and a copper-pillar interconnection 214, 224, 234 extending from the interconnection face 212, 222, 232 towards the compound semiconductor layer 213, 223, 233. Each of the copper-pillar interconnections 214, 224, 234 of the embodiments of FIG. 2 comprises a copper part 215, 225, 235 and an oxidation barrier layer 216, 226, 236. Each of the oxidation barrier layers 216, 226, 236 of the embodiments of FIG. 2 comprises a noble metal and is arranged between a copper part 215, 225, 235 and a compound semiconductor layer 213, 223, 233.

In the embodiment of FIG. 2a, the radiation sensor element 210 further comprises low-temperature solder 217 between the copper-pillar interconnection 214 and the compound semiconductor layer 213. In particular, the low-temperature solder 217 is in direct electrical contact with the oxidation barrier layer 216 and the compound semiconductor layer 213.

In other embodiments, a radiation sensor element may or may not comprise solder, such as low-temperature solder. In other embodiments, wherein a radiation sensor element comprises solder between a copper-pillar interconnection and a compound semiconductor layer, intermediate layers may exist between said solder and said copper-pillar interconnection and/or between said solder and said compound semiconductor layer. As such, a solder may be in electrical contact with a copper-pillar interconnection and/or a compound semiconductor layer directly or directly.

Herein, "solder" may refer to fusible metal suitable for coupling or bonding metal elements by melting and freezing said solder. Further, "low-temperature solder" may refer to solder having a liquidus and/or a solidus temperature of less than 200 °C, or less than 170 °C, or less than 140 °C. A solder may comprise any suitable material(s), for example, indium (In), tin (Sn), bismuth (Bi), Ag, lead (Pb), and/or zinc (Zn).

Generally, an oxidation barrier layer, comprising a noble metal, may improve a mechanical durability of a copper-pillar interconnection when coupled with a low-temperature solder, especially any solder comprising In. This may be related to mitigation of interdiffusion and consequent reduced formation of intermetallics between the solder and a copper part of said copper-pillar interconnection.

The low-temperature solder 217 of the embodiment of FIG. 2a forms a part of an electrical conduction path connecting the read-out integrated circuit 211 and the compound semiconductor layer 213. In other words, a galvanic connection, which also passes via the copper-pillar interconnection 214, exists between the read-out integrated circuit 211 and the compound semiconductor layer 213. Although a radiation sensor element may or may not comprise a galvanic connection between a read-out integrated circuit and a compound semiconductor layer, such galvanic connection may generally be provided in an operable radiation detector.

Throughout this disclosure, a "galvanic connection" may refer to an electrical connection between said elements that enables a constant flow of direct (i.e., unidirectional) electrical current between said elements. A galvanic contact may refer to an electrical connection between two solid elements that provides an electrical direct current path passing through solid matter only.

The radiation sensor element 210 of the embodiment of FIG. 2a also comprises electrically insulating adhesive 218 between the read-out integrated circuit 211 and the compound semiconductor layer 213. Such electrically insulating adhesive may generally improve mechanical stability of a radiation sensor element and/or reduce a probability of electrical breakdown, i.e., sparking, during operation of said radiation sensor element.

In the embodiment of FIG. 2b, the radiation sensor element 220 comprises isotropic electrically conductive adhesive 227 between the copper-pillar interconnection 224 and the compound semiconductor layer 223. Such isotropic electrically conductive adhesive may provide a high-conductance galvanic connection between a copper-pillar interconnection and a compound semiconductor layer. Additionally or alternatively, such isotropic electrically conductive adhesive may facilitate fabricating high-resolution radiation detectors with exceptionally high throughput and yield.

In other embodiments, a radiation sensor element may or may not comprise electrically conductive adhesive, such as isotropic electrically conductive adhesive. In embodiments, wherein a radiation sensor element comprises electrically conductive adhesive between a copper-pillar interconnection and a compound semiconductor layer, intermediate layers may exist between said electrically conductive adhesive and said copper-pillar interconnection and/or between said electrically conductive adhesive and said compound semiconductor layer. As such, electrically conductive adhesive may be in electrical contact with a copper-pillar interconnection and/or a compound semiconductor layer directly or directly.

Herein, "isotropic electrically conductive adhesive" may refer to electrically conductive adhesive having high electrical conductivity, for example, a conductivity of at least 1 S/m, or at least 10 S/m, or at least 100 S/m, or at least 1000 S/m at 20 °C, in any direction. Additionally or alternatively, isotropic electrically conductive adhesive may refer to electrically conductive adhesive comprising pieces of conductive material at a filling level above a percolation threshold.

The isotropic electrically conductive adhesive 227 of the embodiment of the embodiment of FIG. 2b forms a part of an electrical conduction path connecting the read-out integrated circuit 221 and the compound semiconductor layer 223 In particular, the isotropic electrically conductive adhesive 227 is in direct electrical contact with the copper-pillar interconnection 224 and the compound semiconductor layer 223.

In the embodiment of FIG. 2b, the isotropic electrically conductive adhesive 227 is provided in the form of at least one pattern covering the interconnection face 222 only partly, i.e., incompletely. Such partial coverage may generally facilitate forming a plurality of galvanically disconnected copper-pillar interconnections extending from an interconnection face of a read-out integrated circuit towards a compound semiconductor layer. Existence of a plurality of such copper-pillar interconnections may enable pixel-wise detection of radiation.

In general, a radiation sensor element may comprise both electrically insulating adhesive and electrically conductive adhesive. As such, the radiation sensor element 220 of the embodiment of FIG. 2b may additionally comprise electrically insulating adhesive between the read-out integrated circuit 221 and the compound semiconductor layer 223, though such electrically insulating adhesive is not specifically illustrated in FIG. 2b. In embodiments, wherein a radiation sensor element comprises both electrically insulating adhesive and electrically conductive adhesive, said electrically insulating adhesive may or may not be formed in an arrangement complementary to an arrangement of said electrically conductive adhesive.

In the embodiment of FIG. 2b, the copper-pillar interconnection 224 comprises a diffusion barrier layer 228 between the copper part 225 and the oxidation barrier layer 226. Such diffusion barrier layer may generally improve oxidation resistance imparted by an oxidation barrier layer, comprising a noble metal. Such improvement may result from inhibition of interdiffusion between a copper part and said oxidation barrier layer. In other embodiments, a copper-pillar interconnection may or may not comprise a diffusion barrier layer between a copper part and an oxidation barrier layer.

Throughout this specification, a "diffusion barrier layer" may refer to a layer arranged between a copper part and an oxidation barrier layer suitable for inhibiting or reducing interdiffusion between said oxidation barrier layer and said copper part. A diffusion barrier layer may generally comprise any suitable material(s), such as Ni and/or chromium (Cr).

The copper-pillar interconnection 224 of the embodiment of FIG. 2b further comprises an adhesion layer 229 between the copper part 225 and the read-out integrated circuit 221. In particular, the adhesion layer 229 extends from the read-out integrated circuit 221 to the copper part 225; therefore, it is in direct electrical contact with both the read-out integrated circuit 221 and the copper part 225.

In other embodiments, a radiation sensor element may or may not comprise a copper-pillar interconnection comprising an adhesion layer between a copper part and a read-out integrated circuit. In other embodiments, wherein a copper-pillar interconnection comprises an adhesion layer, intermediate layers may exist between said adhesion layer and a copper part. As such, an adhesion layer may be in direct or indirect electrical contact with a copper part.

Herein, an "adhesion layer" may refer to a layer arranged between a copper part and a read-out integrated circuit in order to improve a mechanical stability of a copper-pillar interconnection by inhibiting detachment of said copper-pillar interconnection from an interconnection face. Such adhesion layer may also inhibit diffusion of Cu and/or noble metal atoms towards said read-out integrated circuit. An adhesion layer may generally comprise any suitable material(s), such as titanium (Ti) and/or tungsten (W).

Incidentally, also the copper-pillar interconnection 234 of the embodiment of FIG. 2c comprises an adhesion layer 239 between the copper part 235 and the read-out integrated circuit 231. In contrast to the embodiment of FIG. 2b, however, the radiation sensor element 230 of the embodiment of FIG. 2c comprises anisotropic electrically conductive adhesive 237 between the copper-pillar interconnection 234 and the compound semiconductor layer 233.

Such anisotropic electrically conductive adhesive may generally enable coupling a read-out integrated circuit to a compound semiconductor layer, even if said anisotropic electrically conductive adhesive covers an interconnection face entirely and radiation is to be detected in a pixel-wise manner. Usage of high-coverage layers of anisotropic electrically conductive adhesive may in turn facilitate and expedite fabrication of a radiation sensor element.

In other embodiments, a radiation sensor element may or may not comprise anisotropic electrically conductive adhesive between a copper-pillar interconnection and a compound semiconductor layer.

Throughout this specification, "anisotropic electrically conductive adhesive" may refer to electrically conductive adhesive having low electrical conductivity, for example, a conductivity of less than 10 S/m, or less than 1 S/m, or less than 0.1 S/m in at least one direction. Additionally or alternatively, anisotropic electrically conductive adhesive may refer to electrically conductive adhesive comprising pieces of conductive material at a filling level at or below a percolation threshold.

The anisotropic electrically conductive adhesive 237 of the embodiment of FIG. 2c comprises a plurality of conductive particles 238. The conductive particles 238 are embedded in an insulating matrix. The insulating matrix of the embodiment of FIG. 2c may comprise, for example, a thermosetting polymer resin, such as an epoxy resin.

In the embodiment of FIG. 2c, a first and a second electrical conduction path exist between the read-out integrated circuit 231 and the compound semiconductor layer 233. The first electrical conduction path passes through the adhesion layer 239, the copper part 235, the oxidation barrier layer 236, and a single conductive particle 238. Said single conductive particle 238 is situated at an apex of the copper-pillar interconnection 234. On the other hand, the second electrical conduction path passes through the adhesion layer 239, the copper part 235, the oxidation barrier layer 236, and each of two aggregated conductive particles 238.

The anisotropic electrically conductive adhesive 237 of the embodiment of FIG. 2c is depicted as covering the interconnection face 232 completely. In other embodiments, wherein a radiation sensor element comprises anisotropic electrically conductive adhesive, said anisotropic electrically conductive adhesive may cover an interconnection face at least partly, i.e., partly or completely.

Although not specifically illustrated in FIG. 2c, the radiation sensor element 230 of the embodiment of FIG. 2c may additionally comprise electrically insulating adhesive between the read-out integrated circuit 231 and the compound semiconductor layer 233.

In the embodiment of FIG. 2c, the copper-pillar interconnection element 234 further comprises a projecting lip part 240 at its end opposite the interconnection face 232. Such lip part in a copper-pillar interconnection element may generally provide with increased contact surface between said copper-pillar interconnection element and any material, such as solder or electrically conductive adhesive, arranged between said copper-pillar interconnection element and a compound semiconductor layer. This may increase an overall conductance of an electrical conduction path between a read-out integrated circuit and said compound semiconductor layer.

Herein, a "lip part" may refer to a raised and/or extended part extending at and/or along an edge and/or an end of a structure. In particular, a "projecting" lip part may refer to a lip part projecting in direction(s) substantially parallel to an interconnection face. Additionally or alternatively, a projecting lip part may extend laterally beyond a pillar-shaped part, e.g., at least part of a copper part, of a copper-pillar interconnection element.

It is to be understood that any of the preceding embodiments of the first aspect may be used in combination with each other. In other words, several of the embodiments may be combined together to form a further embodiment of the first aspect.

Above, mainly structural, and material aspects related to radiation sensor elements are discussed. In the following, more emphasis will lie on aspects related to methods for fabricating copper-pillar interconnections. What is said above about the ways of implementation, definitions, details, and advantages related to the structural and material aspects apply, mutatis mutandis, to the method aspects discussed below. The same applies vice versa.

It is specifically to be understood that a method according to the second aspect may be used to provide a radiation sensor element according to the first aspect and any number of embodiments described in relation to the first aspect. Correspondingly, any radiation sensor element according to any embodiment of the first aspect may be fabricated using a method according to the second aspect.

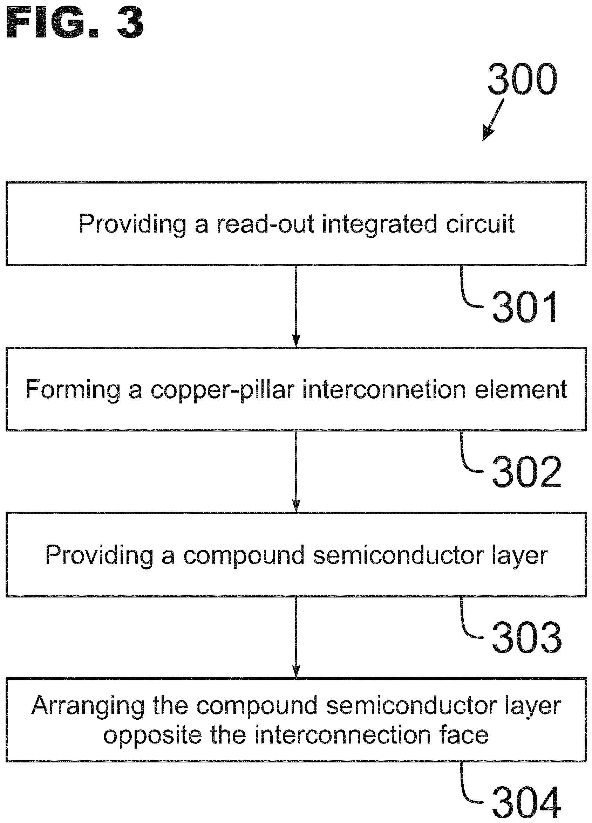

FIG. 3 illustrates a method 300 for fabricating a radiation sensor element according to an embodiment.

The method 300 of the embodiment of FIG. 3 comprises providing a read-out integrated circuit 301 having an interconnection face, forming a copper-pillar interconnection element 302 on the interconnection face, providing a compound semiconductor layer 303, and arranging the compound semiconductor layer opposite the interconnection face 304 such that the copper-pillar interconnection element extends from the interconnection face towards the compound semiconductor layer.

In the embodiment of FIG. 3, the copper-pillar interconnection element comprises a copper part and an oxidation barrier layer, comprising a noble metal, and the oxidation barrier layer is arranged between the copper part and the compound semiconductor layer.

In other embodiments, a method for fabricating a radiation sensor element may comprise steps implementing processes corresponding to the processes 301, 302, 303, 304 of the method 300 of the embodiment of FIG. 3. In said other embodiments, a galvanic connection may or may not be formed between a read-out integrated circuit and a compound semiconductor layer via a copper-pillar interconnection element.

Generally, steps of a method for fabricating a radiation sensor element implementing processes corresponding to any of the processes 301, 302, 303, 304 of the method 300 of the embodiment of FIG. 3 need not be executed in a fixed order.

In general, a method for fabricating a radiation sensor element may comprise any number of additional processes or steps that are not disclosed herein in connection to the method 300 of the embodiment of FIG. 3.

For example, in an embodiment, a copper-pillar interconnection element is formed at least partly electrolytically. In said embodiment, a copper part and/or an oxidation barrier layer may be formed electrolytically.

In another embodiment, which may be in accordance with the preceding embodiment, a copper-pillar interconnection element comprises a projecting lip part at its end opposite the interconnection face.

In another embodiment, which may be in accordance with any of the two preceding embodiments, a copper-pillar interconnection element comprises a diffusion barrier layer between a copper part and an oxidation barrier layer of said copper-pillar interconnection element.

In another embodiment, which may be in accordance with any of the preceding embodiments, a method for fabricating a radiation sensor element further comprises providing electrically conductive adhesive, arranging the electrically conductive adhesive between a copper-pillar interconnection element and a compound semiconductor layer, and coupling a read-out integrated circuit and the compound semiconductor layer by adhesive bonding. In said embodiment, said arrangement of the electrically conductive adhesive may or may not occur concurrently with the arrangement of a compound semiconductor layer opposite an interconnection face, for example, by applying the electrically conductive adhesive onto a surface of a compound semiconductor device comprising the compound semiconductor layer prior to arranging the compound semiconductor layer opposite an interconnection face. In said embodiment, the electrically conductive adhesive may or may not correspond to anisotropic electrically conductive adhesive.

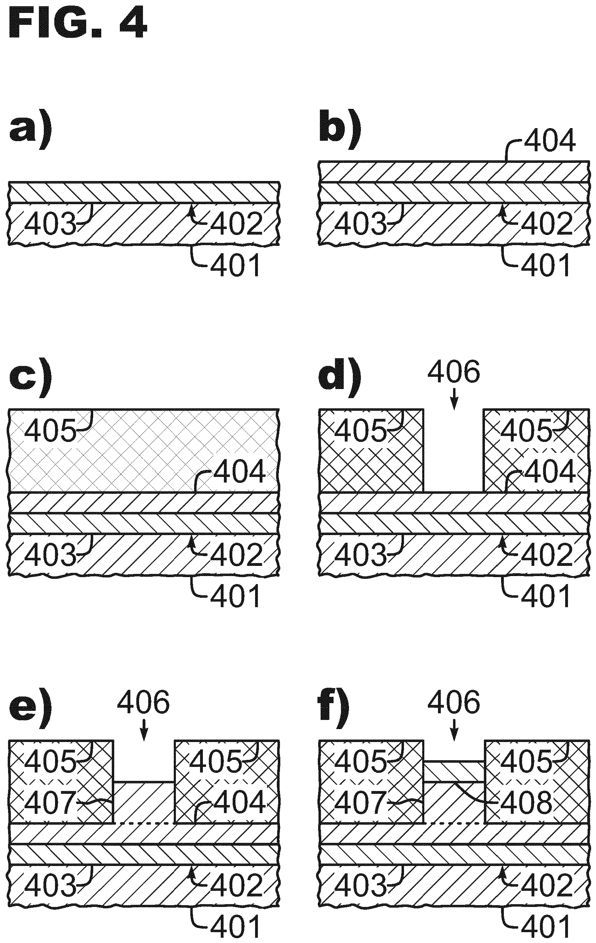

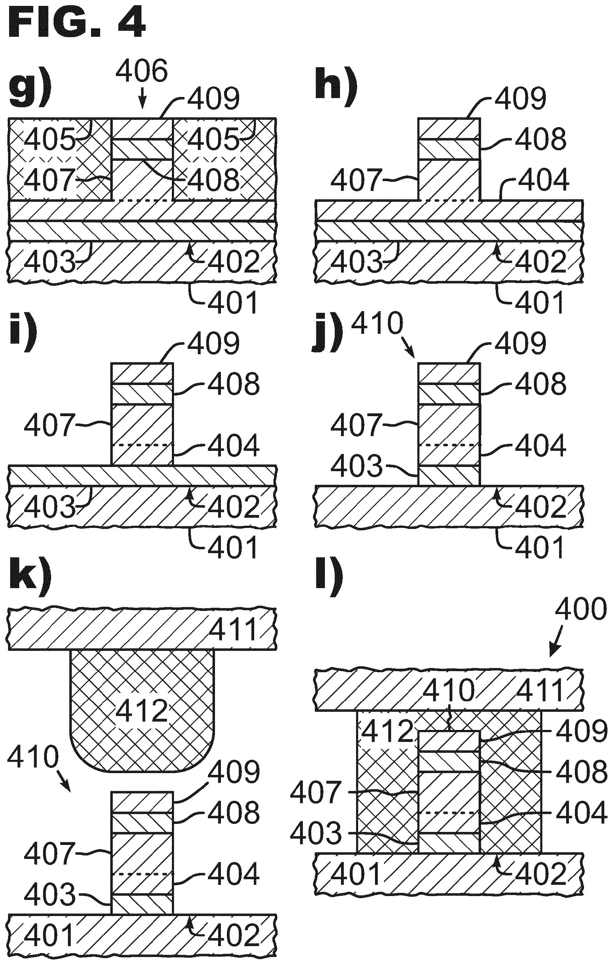

FIGs. 4a through 4l, collectively referred to throughout this specification as FIG. 4, depict a series of subsequent stages of a method for fabricating an exemplary radiation sensor element 400 according to an embodiment.

First, as shown in FIG. 4a, a read-out integrated circuit 401 having an interconnection face 402 is provided. The read-out integrated circuit 401 comprises crystalline silicon. In other embodiments, read-out integrated circuit may or may not comprise silicon, such as crystalline silicon.

In the embodiment of FIG. 4, an electrically conductive adhesion layer 403 is formed onto the interconnection face 402. In other embodiments, an adhesion layer may or may not be provided.

The adhesion layer 403 of the embodiment of FIG. 4 comprises Ti and W. In other embodiments, an adhesion layer may comprise Ti, W, and/or any other suitable materials.

In the embodiment of FIG. 4, the adhesion layer 403 is deposited by sputtering. In other embodiments, an adhesion layer may be formed by any suitable method, e.g., sputtering or evaporation.

As depicted in FIG. 4b, following the deposition of the adhesion layer 403, a seed layer 404 is formed onto the adhesion layer 403. In other embodiments, a seed layer may or may not be provided.

The seed layer 404 of the embodiment of FIG. 4 comprises copper. In other embodiments, a seed layer may comprise Cu and/or any other suitable materials.

In the embodiment of FIG. 4, the seed layer 404 is deposited by sputtering. In other embodiments, a seed layer may be formed by any suitable method, e.g., sputtering or evaporation.

As illustrated in FIG. 4c, following the deposition of the seed layer 404, an electrically insulating masking layer 405 is formed onto the seed layer 404. In other embodiments, such masking layer may or may not be required.

The masking layer 405 of the embodiment of FIG. 4 comprises photoresist. In other embodiments, a seed layer may comprise photoresist and/or any other suitable materials.

In the embodiment of FIG. 4, the masking layer 405 is deposited by spin coating. In other embodiments, a masking layer may be formed by any suitable method, e.g., spin coating, spray coating, or chemical vapor deposition.

The masking layer 405 of the embodiment of FIG. 4 has a thickness perpendicular to the interconnection face 402 of about 10 micrometers (µm). In other embodiments, a masking layer may have any suitable thickness, for example, in a range from a few micrometers (e.g., 5 µm or less) to some tens of micrometers (e.g., 50 µm or more).

As shown in FIG. 4d, following the deposition of the masking layer 405, a through-hole 406 is formed in the masking layer 405. Although in FIG. 4 only one through-hole 406 is depicted, a masking layer may generally comprise any number, for example, one or more, two or more, or 100 or more, of through-holes.

In the embodiment of FIG. 4, the through-hole 406 is formed via a conventional photolithography procedure, comprising photoresist exposure and developing steps. In other embodiments, a through-hole may be formed by any suitable method, e.g., photolithography or etching.

As illustrated in FIG. 4e, following the formation of the through-hole 406, a protrusion 407, comprising copper, is formed, the protrusion 407 extending from the seed layer 404 in the through-hole 406. In other embodiments, such protrusion may or may not be formed.

In the embodiment of FIG. 4, the protrusion 407 is formed electrolytically by electrodeposition. In other embodiments, a protrusion may be formed by any suitable method(s), for example, electrolytical methods (e.g., electrodeposition or electroless deposition).

In the embodiment of FIG. 4, the seed layer 404 is formed in order to facilitate the formation of the protrusion 407 by electrodeposition.

As illustrated in FIG. 4f, following the formation of the protrusion 407, a diffusion barrier layer 408 is formed. In other embodiments, a diffusion barrier layer may or may not be provided.

The diffusion barrier layer 408 of the embodiment of FIG. 4 comprises Ni. In other embodiments, a diffusion barrier layer 408 may comprise Ni and/or any other suitable materials.

The diffusion barrier layer 408 of the embodiment of FIG. 4 has a thickness perpendicular to the interconnection face 402 of about 1 µm. In other embodiments, a diffusion barrier layer may have any suitable thickness, for example, in a range from a fraction of a micrometer (e.g., 0.5 µm or less) to a few micrometers (e.g., 5 µm or more).

In the embodiment of FIG. 4, the diffusion barrier layer 408 is formed electrolytically by electrodeposition. In other embodiments, a diffusion barrier layer may be formed by any suitable method, for example, evaporation, sputtering, electrodeposition, or electroless deposition.

As shown in FIG. 4g, following the formation of the diffusion barrier layer 408, an oxidation barrier layer 409, comprising a noble metal, is formed.

The oxidation barrier layer 409 of the embodiment of FIG. 4 comprises gold. In other embodiments, an oxidation barrier layer 409 may comprise any noble metal(s) (e.g., Au, Ag, Rh, Pt, Pd, Ru, Os, and/or Ir) and/or any other suitable materials.

In the embodiment of FIG. 4, the oxidation barrier layer 409 is formed electrolytically by electrodeposition. In other embodiments, an oxidation barrier layer may be formed by any suitable method, for example, evaporation, sputtering, electrodeposition, or electroless deposition.

The oxidation barrier layer 409 of the embodiment of FIG. 4 has a thickness perpendicular to the interconnection face 402 of about 1 µm. In other embodiments, a diffusion barrier layer may have any suitable thickness, for example, in a range from a fraction of a micrometer (e.g., 0.2 µm or less) to a few micrometers (e.g., 3 µm or more).

In the embodiments of FIG. 4, the diffusion barrier layer 408 is arranged between the protrusion 407, comprising copper, and the oxidation barrier layer 409, comprising gold, in order to inhibit interdiffusion of gold and copper.

As depicted in FIG. 4h, following the formation of the oxidation barrier layer 409, the masking layer 405 is removed. In other embodiments, a masking layer may or may not be removed.

In the embodiment of FIG. 4, the masking layer 405 is removed by subjecting the masking layer 405 to a photoresist stripper solution. Such procedure may be referred to as photoresist stripping. In other embodiments, a masking layer may be removed by any suitable method, e.g., photoresist stripping, plasma ashing, dissolution, or etching.

As illustrated in FIG. 4i, following the removal of the masking layer 405, the seed layer 404 is partially removed from areas not covered by the protrusion 407.

The seed layer 404 of the embodiment of FIG. 4 is partially removed by wet etching. A seed layer, comprising copper, may be etched, for example, using any commercial liquid copper etchant or an aqueous etching solution comprising iron (III) chloride (FeCl₃) and hydrochloric acid (HCl). In other embodiments, a seed layer may be partially removed by any suitable method, e.g., wet etching.

In the embodiment of FIG. 4, following the partial removal of the seed layer 404, the remaining seed layer 404 and the protrusion 407, both comprising copper, form a single copper part.

As illustrated in FIG. 4j, following the partial removal of the seed layer 404, the adhesion layer 403 is partially removed from areas not covered by the remaining seed layer 404.

The adhesion layer 403 of the embodiment of FIG. 4 is partially removed by wet etching. An adhesion layer, comprising titanium and tungsten, may be etched, for example, using any suitable commercial etchant or a concentrated aqueous solution of hydrogen peroxide (H₂O₂). In other embodiments, a seed layer may be partially removed by any suitable method, e.g., wet etching.

In embodiments, wherein a method for fabricating a radiation sensor element comprises forming a seed layer and/or an adhesion layer, partial removal of said layers may enable pixel-wise detection of radiation. Generally, removal of a masking layer may facilitate such partial removal of a seed layer and/or an adhesion layer.

In the embodiment of FIG. 4, following the partial removal of the adhesion layer 403, formation of a copper-pillar interconnection element 410, extending from the interconnection face 402, is complete. The copper-pillar interconnection element 410 of the embodiment of FIG. 4 comprises the adhesion layer 403, the seed layer 404, the protrusion 407, the diffusion barrier layer 408, and the oxidation barrier layer 409.

As shown in FIG. 4k, following the formation of the copper-pillar interconnection element 410, a compound semiconductor layer 411 is provided.

The compound semiconductor layer 411 of the embodiment of FIG. 4 comprises CdTe. In other embodiments, a compound semiconductor layer may comprise any compound semiconductor material(s) (e.g., CdTe, CdZnTe, and/or cadmium manganese telluride (CdMnTe)).

The compound semiconductor layer 411 of the embodiment of FIG. 4 has a thickness of about 0.75 millimeters (mm). In other embodiments, a compound semiconductor layer may have any suitable thickness, for example, in a range from a fraction of a millimeter (e.g., 0.1 mm or less) to a few millimeters (e.g., 3 mm or more) . A higher compound semiconductor layer thickness may generally improve an efficiency of a radiation sensor element.

As shown in FIG. 4k, in addition to the provision of the compound semiconductor layer 411, isotropic electrically conductive adhesive 412 is provided. In other embodiments, electrically conductive adhesive, such as isotropic electrically conductive adhesive may or may not be provided.

The isotropic electrically conductive adhesive 412 of the embodiment of FIG. 4 is arranged between the copper-pillar interconnection element 410 and the compound semiconductor layer 411. In other embodiments, wherein a radiation sensor element comprises electrically conductive adhesive, said electrically conductive adhesive may or may not be arranged between a copper-pillar interconnection element and a compound semiconductor layer.

In the embodiment of FIG. 4, the isotropic electrically conductive adhesive 412 is deposited onto the compound semiconductor layer 411 by syringe dispensing. In other embodiments, electrically conductive adhesive, such as isotropic electrically conductive adhesive, may be deposited by any suitable method, e.g., screen printing, syringe dispensing, or spray coating. In said other embodiments, electrically conductive adhesive may be deposited on any suitable surface(s), for example, a surface of a compound semiconductor layer, a surface of any additional layer on said compound semiconductor layer, and/or an interconnection face.

Although omitted from FIG. 4, any number of additional structural elements, such as layers, may generally exist between a compound semiconductor layer and electrically conductive adhesive. Such elements may be configured to improve adhesion, to prevent diffusion-related effects, and/or to reduce electrical resistance between said compound semiconductor layer and said electrically conductive adhesive. Such elements may form, for example, a bonding pad on the compound semiconductor layer.

As shown in FIG. 4l, after the provision of the isotropic electrically conductive adhesive 412 and arrangement thereof between the copper-pillar interconnection element 410 and the compound semiconductor layer 411, the read-out integrated circuit 401 and the compound semiconductor layer 411 are coupled together. In operable radiation detectors, a read-out integrated circuit and a compound semiconductor layer may generally be coupled together.

In the embodiment of FIG. 4, the coupling of the read-out integrated circuit 401 and the compound semiconductor layer 411 is effected by adhesive bonding. Generally, coupling a read-out integrated circuit 401 and the compound semiconductor layer by adhesive bonding may enable achieving reliable coupling using low bonding temperatures, for example, a bonding temperature of less than 140 °C. In other embodiments, any suitable methods may be used for coupling together a read-out integrated circuit and a compound semiconductor layer. In other embodiments, wherein a read-out integrated circuit and a compound semiconductor layer are coupled together by adhesive bonding, any suitable bonding temperature(s), such as a bonding temperature of less than 140 °C, may be utilized.

In general, a lower bonding temperature may increase overall fabrication yield for radiation sensor elements, owing to temperature-sensitivity of compound semiconductor layers, especially those comprising CdTe, CdZnTe, and/or CdMnTe.

In the embodiment of FIG. 4, a galvanic connection, passing via the copper-pillar interconnection element 410, exists between the read-out integrated circuit 401 and the compound semiconductor layer 411.

Following adhesive bonding of the read-out integrated circuit 401 and the compound semiconductor layer 411, formation of the radiation sensor element 400 is complete. In other embodiments, a method for fabricating a radiation sensor element may comprise a series of stages similar or different to the stages of the method of the embodiment of FIG. 4.

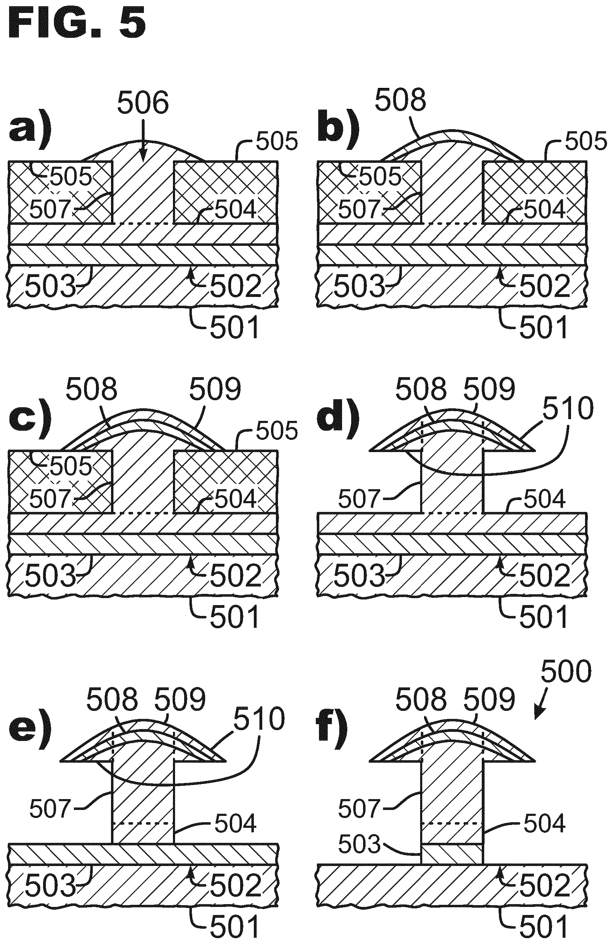

FIGs. 5a through 5f, collectively referred to throughout this specification as FIG. 5, depict a series of subsequent stages of a method for fabricating a copper-pillar interconnection element 500 according to an embodiment. Various elements of the embodiment of FIG. 5 may generally be identical or similar to corresponding elements of the radiation sensor element 400 of the embodiment of FIG. 4. Such similarity may be related, in particular, to material and fabrication method aspects.

As shown in FIG. 5a, at a certain stage of the method of the embodiment of FIG. 5, a semi-finished version of the copper-pillar interconnection element 500 comprises a read-out integrated circuit 501 having an interconnection face 502, an adhesion layer 503 on the interconnection face 502, a seed layer 504 on the adhesion layer 503, a patterned masking layer 505, comprising a through-hole 506, on the seed layer 504, and a protrusion 507 extending from the seed layer 504 inside the through-hole 506 away from the interconnection face 502.

In the embodiment of FIG. 5, the protrusion 507, comprising copper, extends beyond the extent of the through-hole 506. As such, a part of the protrusion 507 projects laterally in directions parallel to the interconnection face 502.

As shown in FIG. 5b, a diffusion barrier layer 508 is then formed onto the protrusion 507. In other embodiments, a diffusion barrier layer may or may not be provided.

As illustrated in FIG. 5c, following the formation of the diffusion barrier layer 508, an oxidation barrier layer 509, comprising a noble metal, is formed onto the diffusion barrier layer 508. In other embodiments, an oxidation barrier layer may be formed onto any suitable element, for example, onto a protrusion, comprising copper, or a diffusion barrier layer.

In the embodiment of FIG. 5, laterally projecting parts of the protrusion 507, the diffusion barrier layer 508, and the oxidation barrier layer 509 form a projecting lip part 510. In other embodiments, a copper-pillar interconnection element may or may not be provided with a lip part. In said other embodiments, said lip part may be formed at least partially by a copper part and/or a diffusion barrier layer, in addition to an oxidation barrier layer.

Although the lip part 510 is depicted in the cross-sectional drawing of FIG. 5 as two separate sections, a copper-pillar interconnection element may generally comprise any number of (i.e., zero or more) lip parts. In particular, a lip part may surround a periphery of a part of a copper-pillar interconnection element extending substantially perpendicularly away from an interconnection face of a read-out integrated circuit.

As depicted in FIGs. 5d through 5f, following the formation of the oxidation barrier layer 509, the masking layer 505 is removed, and the seed layer 504 as well as the adhesion layer 503 are partially removed in order to form the copper-pillar interconnection element 500.

In other embodiments, a method for fabricating a radiation sensor element may comprise stages similar or different to the stages of the method of the embodiment of FIG. 5.

In an embodiment, wherein a copper-pillar interconnection element may or may not comprise a lip part, an adhesion layer, and/or a diffusion barrier layer, solder may be arranged between said copper-pillar interconnection and a compound semiconductor layer. In said embodiment, said solder may be formed by any suitable method(s), for example, by electrodeposition. Such solder may generally be coupled by a conventional reflow process, for example, to a bonding pad on said compound semiconductor layer or any suitable intermediate layer.

In another embodiment, wherein a copper-pillar interconnection element may or may not comprise a lip part, an adhesion layer, and/or a diffusion barrier layer, anisotropic electrically conductive adhesive may be arranged between said copper-pillar interconnection and a compound semiconductor layer. In said embodiment, said anisotropic electrically conductive adhesive may be deposited by any suitable method(s), for example, by screen printing or syringe dispensing.

It is obvious to a person skilled in the art that with the advancement of technology, the basic idea of the invention may be implemented in various ways. The invention and its embodiments are thus not limited to the examples described above, instead they may vary within the scope of the claims.

It will be understood that any benefits and advantages described above may relate to one embodiment or may relate to several embodiments. The embodiments are not limited to those that solve any or all of the stated problems or those that have any or all of the stated benefits and advantages.

The term "comprising" is used in this specification to mean including the feature(s) or act(s) followed thereafter, without excluding the presence of one or more additional features or acts. It will further be understood that reference to 'an' item refers to one or more of those items.

### REFERENCE SIGNS

- 100: radiation sensor element
- 110: read-out integrated circuit
- 111: interconnection face
- 112: interconnection pad
- 120: compound semiconductor layer
- 121: radiation receiving face
- 130: copper-pillar interconnection element
- 131: copper part
- 132: oxidation barrier layer
- 140: electrically conductive adhesive
- 210: radiation sensor element
- 211: read-out integrated circuit
- 212: interconnection face
- 213: compound semiconductor layer
- 214: copper-pillar interconnection element
- 215: copper part
- 216: oxidation barrier layer
- 217: low-temperature solder
- 218: electrically insulating adhesive
- 220: radiation sensor element
- 221: read-out integrated circuit
- 222: interconnection face
- 223: compound semiconductor layer
- 224: copper-pillar interconnection element
- 225: copper part
- 226: oxidation barrier layer
- 227: isotropic electrically conductive adhesive
- 228: diffusion barrier layer
- 229: adhesion layer
- 230: radiation sensor element
- 231: read-out integrated circuit
- 232: interconnection face
- 233: compound semiconductor layer
- 234: copper-pillar interconnection element
- 235: copper part
- 236: oxidation barrier layer
- 237: anisotropic electrically conductive adhesive
- 238: conductive particle
- 239: adhesion layer
- 240: lip part
- 300: method
- 301: providing a read-out integrated circuit
- 302: forming a copper-pillar interconnection element
- 303: providing a compound semiconductor layer
- 304: arranging the compound semiconductor layer opposite the interconnection face
- 400: radiation sensor element
- 401: read-out integrated circuit
- 402: interconnection face
- 403: adhesion layer
- 404: seed layer
- 405: masking layer
- 406: through-hole
- 407: protrusion
- 408: diffusion barrier layer
- 409: oxidation barrier layer
- 410: copper-pillar interconnection element
- 411: compound semiconductor layer
- 412: isotropic electrically conductive adhesive
- 500: copper-pillar interconnection element
- 501: read-out integrated circuit
- 502: interconnection face
- 503: adhesion layer
- 504: seed layer
- 505: masking layer
- 506: through-hole
- 507: protrusion
- 508: diffusion barrier layer
- 509: oxidation barrier layer
- 510: lip part

## Claims

1. A radiation sensor element (100), comprising:
- a read-out integrated circuit (110) having an interconnection face (111),
- a compound semiconductor layer (120) opposite the interconnection face (111), and
- a copper-pillar interconnection element (130) extending from the interconnection face (111) towards the compound semiconductor layer (120),
wherein the copper-pillar interconnection element (130) comprises a copper part (131) and an oxidation barrier layer (132), comprising a noble metal and arranged between the copper part (131) and the compound semiconductor layer (120).

2. A radiation sensor element (100) according to claim 1, wherein the oxidation barrier layer (132) comprises gold, Au; silver, Ag; rhodium, Rh; platinum, Pt; palladium, Pd; ruthenium, Ru; osmium, Os; and/or iridium, Ir.

3. A radiation sensor element (100) according to claim 2, wherein the oxidation barrier layer (132) comprises at least 90 atomic percent of noble metal or metals.

4. A radiation sensor element (100) according to any of the preceding claims, wherein the compound semiconductor layer (120) comprises cadmium telluride, CdTe; cadmium zinc telluride, CdZnTe; and/or cadmium manganese telluride, CdMnTe.

5. A radiation sensor element (230) according to any of the preceding claims, wherein the copper-pillar interconnection element (234) comprises a projecting lip part (240) at its end opposite the interconnection face (232).

6. A radiation sensor element (220) according to any of the preceding claims, wherein the copper-pillar interconnection element (224) comprises a diffusion barrier layer (228) between the copper part (225) and the oxidation barrier layer (226).

7. A radiation sensor element (220) according to claim 6, wherein the diffusion barrier layer (228) comprises nickel, Ni.

8. A radiation sensor element (210) according to any of the preceding claims, wherein the radiation sensor element (210) further comprises low-temperature solder (217) between the copper-pillar interconnection element (214) and the compound semiconductor layer (213).

9. A radiation sensor element (100) according to any of claims 1 to 7, further comprising electrically conductive adhesive (140) between the copper-pillar interconnection element (130) and the compound semiconductor layer (120).

10. A radiation sensor element (230) according to claim 8, wherein the electrically conductive adhesive is anisotropic electrically conductive adhesive (237).

11. A method (300) for fabricating a radiation sensor element, the method (300) comprising:
- providing a read-out integrated circuit (301) having an interconnection face,
- forming a copper-pillar interconnection element (302) on the interconnection face,
- providing a compound semiconductor layer (303), and
- arranging the compound semiconductor layer opposite the interconnection face (304) such that the copper-pillar interconnection element extends from the interconnection face towards the compound semiconductor layer,
wherein the copper-pillar interconnection element comprises a copper part and an oxidation barrier layer, comprising a noble metal, and the oxidation barrier layer is arranged between the copper part and the compound semiconductor layer.

12. A method (300) according to claim 11, wherein the copper-pillar interconnection element is formed at least partly electrolytically.

13. A method (300) according to claim 11 or 12, further comprising:
- providing electrically conductive adhesive,
- arranging the electrically conductive adhesive between the copper-pillar interconnection element and the compound semiconductor layer, and
- coupling the read-out integrated circuit and the compound semiconductor layer by adhesive bonding.

14. A method (300) according to any of claims 11 to 13, wherein the radiation sensor element is a radiation sensor element (100) according to any of claims 1 to 9.

## Patentansprüche

1. Strahlungssensorelement (100), umfassend:
- eine integrierte Ausleseschaltung (110), die eine Verbindungsfläche (111) aufweist,
- eine Verbindungshalbleiterschicht (120) gegenüber der Verbindungsfläche (111), und
- ein Kupfer-Säulen-Verbindungselement (130), das sich von der Verbindungsfläche (111) in Richtung der Verbindungshalbleiterschicht (120) erstreckt,
wobei das Kupfer-Säulen-Verbindungselement (130) einen Kupferteil (131) und eine Oxidationssperrschicht (132) umfasst, die ein Edelmetall umfasst und zwischen dem Kupferteil (131) und der Verbindungshalbleiterschicht (120) angeordnet ist.

2. Strahlungssensorelement (100) nach Anspruch 1, wobei die Oxidationssperrschicht (132) Gold, Au; Silber, Ag; Rhodium, Rh; Platin, Pt; Palladium, Pd; Ruthenium, Ru; Osmium, Os; und/oder Iridium, Ir umfasst.

3. Strahlungssensorelement (100) nach Anspruch 2, wobei die Oxidationssperrschicht (132) mindestens 90 Atomprozent Edelmetall oder Edelmetalle umfasst.

4. Strahlungssensorelement (100) nach einem der vorhergehenden Ansprüche, wobei die Verbindungshalbleiterschicht (120) Cadmiumtellurid, CdTe; Cadmiumzinktellurid, CdZnTe; und/oder Cadmiummangantellurid, CdMnTe umfasst.

5. Strahlungssensorelement (230) nach einem der vorhergehenden Ansprüche, wobei das Kupfer-Säulen-Verbindungselement (234) an seinem der Verbindungsfläche (232) gegenüberliegenden Ende einen vorstehenden Lippenteil (240) umfasst.

6. Strahlungssensorelement (220) nach einem der vorhergehenden Ansprüche, wobei das Kupfer-Säulen-Verbindungselement (224) eine Diffusionssperrschicht (228) zwischen dem Kupferteil (225) und der Oxidationssperrschicht (226) umfasst.

7. Strahlungssensorelement (220) nach Anspruch 6, wobei die Diffusionssperrschicht (228) Nickel, Ni, umfasst.

8. Strahlungssensorelement (210) nach einem der vorhergehenden Ansprüche, wobei das Strahlungssensorelement (210) ferner Niedertemperaturlot (217) zwischen dem Kupfer-Säulen-Verbindungselement (214) und der Verbindungshalbleiterschicht (213) umfasst.

9. Strahlungssensorelement (100) nach einem der Ansprüche 1 bis 7, ferner umfassend einen elektrisch leitfähigen Klebstoff (140) zwischen dem Kupfersäulen-Verbindungselement (130) und der Verbindungshalbleiterschicht (120).

10. Strahlungssensorelement (230) nach Anspruch 8, wobei der elektrisch leitfähige Klebstoff ein anisotroper elektrisch leitfähiger Klebstoff (237) ist.

11. Verfahren (300) zum Herstellen eines Strahlungssensorelements, das Verfahren (300) umfassend die Schritte:
- Bereitstellen einer integrierten Ausleseschaltung (301), die eine Verbindungsfläche aufweist,
- Ausbilden eines Kupfer-Säulen-Verbindungselements (302) auf der Verbindungsfläche,
- Bereitstellen einer Verbindungshalbleiterschicht (303), und
- Anordnen der Verbindungshalbleiterschicht gegenüber der Verbindungsfläche (304) derart, dass sich das Kupfer-Säulen-Verbindungselement von der Verbindungsfläche in Richtung der Verbindungshalbleiterschicht erstreckt,
wobei das Kupfer-Säulen-Verbindungselement einen Kupferteil und eine Oxidationssperrschicht umfasst, die ein Edelmetall umfasst, und die Oxidationssperrschicht zwischen dem Kupferteil und der Verbindungshalbleiterschicht angeordnet ist.

12. Verfahren (300) nach Anspruch 11, wobei das Kupfer-Säulen-Verbindungselement zumindest teilweise elektrolytisch gebildet wird.

13. Verfahren (300) nach Anspruch 11 oder 12, ferner umfassend die Schritte:
- Bereitstellen von elektrisch leitfähigem Klebstoff,
- Anordnen des elektrisch leitfähigen Klebstoffs zwischen dem Kupfer-Säulen-Verbindungselement und der Verbindungshalbleiterschicht, und
- Koppeln der integrierten Ausleseschaltung und der Verbindungshalbleiterschicht durch Kleben.

14. Verfahren (300) nach einem der Ansprüche 11 bis 13, wobei das Strahlungssensorelement ein Strahlungssensorelement (100) nach einem der Ansprüche 1 bis 9 ist.

## Revendications

1. Élément de capteur de rayonnement (100), comprenant :
- un circuit intégré de lecture (110) ayant une face d'interconnexion (111),
- une couche de semi-conducteur composé (120) opposée à la face d'interconnexion (111), et
- un élément d'interconnexion de type pilier de cuivre (130) s'étendant de la face d'interconnexion (111) à la couche de semi-conducteur composé (120),
dans lequel l'élément d'interconnexion de type pilier de cuivre (130) comprend une partie en cuivre (131) et une couche de barrière d'oxydation (132), comprenant un métal noble et disposée entre la partie en cuivre (131) et la couche de semi-conducteur composé (120).

2. Élément de capteur de rayonnement (100) selon la revendication 1, dans lequel la couche de barrière d'oxydation (132) comprend de l'or, Au ; de l'argent, Ag ; du rhodium, Rh ; du platine, Pt; du palladium, Pd ; du ruthénium, Ru ; de l'osmium, Os ; et/ou de l'iridium, Ir.

3. Élément de capteur de rayonnement (100) selon la revendication 2, dans lequel la couche de barrière d'oxydation (132) comprend au moins 90 pour cent atomique de métal noble ou de métaux.

4. Élément de capteur de rayonnement (100) selon l'une quelconque des revendications précédentes, dans lequel la couche de semi-conducteur composé (120) comprend du tellurure de cadmium, CdTe ; du tellurure de cadmium-zinc, CdZnTe ; et/ou du tellurure de cadmium-manganèse, CdMnTe.

5. Élément de capteur de rayonnement (230) selon l'une quelconque des revendications précédentes, dans lequel l'élément d'interconnexion de type pilier de cuivre (234) comprend une partie de bord faisant saillie (240) à son extrémité opposée à la face d'interconnexion (232).

6. Élément de capteur de rayonnement (220) selon l'une quelconque des revendications précédentes, dans lequel l'élément d'interconnexion de type pilier de cuivre (224) comprend une couche de barrière de diffusion (228) entre la partie en cuivre (225) et la couche de barrière d'oxydation (226).

7. Élément de capteur de rayonnement (220) selon la revendication 6, dans lequel la couche de barrière de diffusion (228) comprend du nickel, Ni.

8. Élément de capteur de rayonnement (210) selon l'une quelconque des revendications précédentes, dans lequel l'élément de capteur de rayonnement (210) comprend en outre une brasure basse température (217) entre l'élément d'interconnexion de type pilier de cuivre (214) et la couche de semi-conducteur composé (213).

9. Élément de capteur de rayonnement (100) selon l'une quelconque des revendications 1 à 7, comprenant en outre un adhésif électriquement conducteur (140) entre l'élément d'interconnexion de type pilier de cuivre (130) et la couche de semi-conducteur composé (120).

10. Élément de capteur de rayonnement (230) selon la revendication 8, dans lequel l'adhésif électriquement conducteur est un adhésif électriquement conducteur anisotrope (237).

11. Procédé (300) de fabrication d'un élément de capteur de rayonnement, le procédé (300) comprenant :
- la fourniture d'un circuit intégré de lecture (301) ayant une face d'interconnexion,
- la formation d'un élément d'interconnexion de type pilier de cuivre (302) sur la face d'interconnexion,
- la fourniture d'une couche de semi-conducteur composé (303), et
- l'agencement de la couche de semi-conducteur composé opposée à la face d'interconnexion (304) de telle sorte que l'élément d'interconnexion de type pilier de cuivre s'étend de la face d'interconnexion à la couche de semi-conducteur composé,
dans lequel l'élément d'interconnexion de type pilier de cuivre comprend une partie en cuivre et une couche de barrière d'oxydation, comprenant un métal noble, et la couche de barrière d'oxydation est disposée entre la partie en cuivre et la couche de semi-conducteur composé.

12. Procédé (300) selon la revendication 11, dans lequel l'élément d'interconnexion de type pilier de cuivre est formé au moins partiellement électrolytiquement.

13. Procédé (300) selon la revendication 11 ou 12, comprenant en outre :
- la fourniture d'un adhésif électriquement conducteur,
- l'agencement de l'adhésif électriquement conducteur entre l'élément d'interconnexion de type pilier de cuivre et la couche de semi-conducteur composé, et
- le couplage du circuit intégré de lecture et de la couche de semi-conducteur composé par liaison adhésive.

14. Procédé (300) selon l'une quelconque des revendications 11 à 13, dans lequel l'élément de capteur de rayonnement est un élément de capteur de rayonnement (100) selon l'une quelconque des revendications 1 à 9.
